# DEMANDE DE BREVET EUROPEEN

(11) **EP 2 141 779 A1**
(43) Date de publication de la demande: **06.01.2010**
(21) Numéro de dépôt: 09164499.7
(22) Date de dépôt: 03.07.2009
(51) Int. Cl.: H01S 5/34

(54) **Dispositif de type détecteur à cascades quantiques à injecteur haut**

(30) Priorité: 04.07.2008 FR 0803812
(71) Demandeur: Thales, 92200 Neuilly-sur-Seine (FR)
(72) Inventeur: Carras, Mathieu, 94250 Gentilly (FR)
(74) Mandataire: Esselin, Sophie

(57) **Abrégé**

L'invention concerne un dispositif à cascades quantiques de type détecteur comportant deux électrodes pour appliquer un champ électrique de commande, et un guide d'ondes disposé entre les deux électrodes, ledit dispositif comprenant une région de gain formée de plusieurs couches et comprenant une alternance de strates d'un premier type définissant chacune une barrière quantique et de strates d'un second type définissant chacune un puits quantique, chaque couche de la région à gain comportant une barrière d'injection présentant une sous-bande d'injection de porteurs de charge avec un niveau inférieur d'énergie dit niveau injecteur (i) et une zone active, ladite zone active étant formée d'un ensemble de paires de strates constituées à partir de matériaux semiconducteurs de telle manière que chacun des puits présente au moins une sous-bande supérieure dite troisième sous-bande (3), une sous-bande médiane dite seconde sous-bande (2) et une sous-bande inférieure dite première sous-bande (1), la différence de potentiel entre les troisième et deuxième sous-bandes étant telle que la transition d'un électron de la troisième sous-bande à la deuxième sous-bande émet une énergie correspondant à celle nécessaire pour l'émission d'un photon, **caractérisé en ce que** :
- la zone active possède en outre une quatrième sous-bande (4) située au dessus de la troisième sous-bande ;
- ladite quatrième sous-bande étant telle qu'en l'absence de champ électrique appliqué aux électrodes, le niveau injecteur de la barrière d'injection est inférieure au niveau de ladite quatrième sous-bande et supérieur au niveau de la troisième sous-bande et qu'en présence d'un champ appliqué aux électrodes le niveau injecteur de porteurs de charge (i) devient supérieur ou égal au niveau de la quatrième sous-bande, de manière à générer un phénomène de relaxation rapide entre le niveau injecteur et la quatrième sous-bande, la quatrième sous bande étant à une distance en énergie de la troisième sous bande permettant une relaxation par phonon optique.

## Description

Le domaine de l'invention est celui des dispositifs à cascades quantiques dans le moyen infrarouge et typiquement dans les longueurs d'onde 3-10 microns, élaborés à partir de matériaux semiconducteurs III-V.

De manière générale il est connu des lasers à cascade quantique comportant deux électrodes pour appliquer un champ électrique de commande, un guide d'ondes disposé entre les électrodes et une structure comprenant une région à gain formée de plusieurs couches qui comprennent une alternance de strates d'un premier type définissant chacune une barrière quantique et de strates d'un second type définissant chacune un puits quantique, ces strates étant constituées de premier et second matériaux semiconducteurs, respectivement constitutifs des barrières et des puits.

La structure comporte en outre deux couches de confinement optique disposées de part et d'autre de la région à gain. Ces lasers sont obtenus par une suite complexe d'étapes de dépôt de couches sur un substrat mono-cristallin et d'étapes de gravure chimique ou physico-chimiques destinées à constituer le réseau de diffraction et structurer le laser.

Les matériaux constitutifs des barrières et des puits sont choisis de manière à ce qu'ils présentent une maille égale à celle du substrat, de façon à conserver la structure monocristalline dans toute l'épaisseur du laser.

De manière générale on définit dans l'ensemble de la description, une strate comme étant une couche unitaire de composition homogène de faible épaisseur et une couche comme étant un ensemble de strates assurant une même fonction.

La différence de potentiel cristallin des premier et second matériaux constituant respectivement les strates de premier et second types définit par effet de quantification, un ou plusieurs états bidimensionnels appelés niveaux d'énergie ou sous-bandes. Un motif constitué de plusieurs de ces paires de strates constitue le milieu à gain du Laser et est répété de façon périodique N fois.

Chacune des périodes comporte une zone active et une zone de relaxation d'énergie. L'application d'un champ électrique aux bornes des électrodes engendre un courant de porteurs de charge à l'intérieur, notamment de la région de gain. L'émission d'un rayonnement laser est engendrée par la transition de porteurs de charge dans la zone active d'une première à une deuxième sous-bande. Ce phénomène, appelé transition inter-sous-bandes est accompagné de l'émission d'un photon.

Le fonctionnement de ce type de laser est basé sur l'occurrence de transitions électroniques entre différents niveaux permis d'énergie au sein de la bande de conduction des structures quantiques semiconductrices et par la transition de porteurs de charge dans la zone active d'une première à une deuxième sous-bande, accompagné de l'émission de phonons optiques.

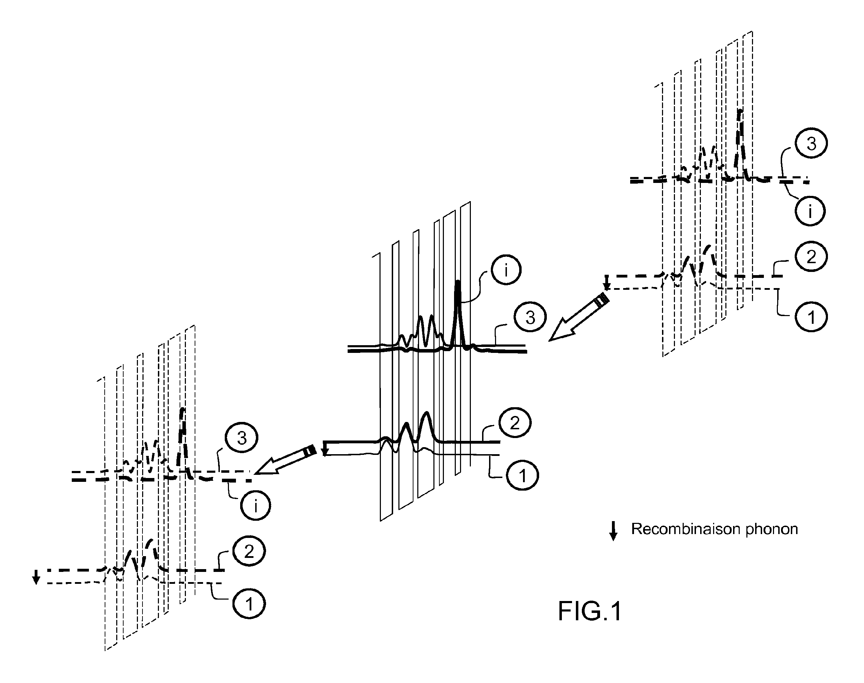

La figure 1 illustre un exemple de laser à cascades quantiques selon l'art connu présentant des niveaux discrets d'énergie appelés sous-bandes. Sont représentés les différentes sous-bandes et la probabilité de présence de porteurs de charge sur lesdites sous-bandes respectivement référencées i, 3, 2 et 1. La sous-bande i correspond à une sous-bande dite d'injection comportant une grande quantité d'électrons injectés classiquement par dopage. Sous l'action d'un champ électrique adapté, des électrons présents sur cette sous-bande i sont amenés à basculer sur la sous-bande supérieure 3, lesdits électrons par transition électronique sur la sous-bande 2, génèrent l'émission d'un phonon optique, les porteurs de charge de la sous-bande 2 pouvant alors être extraits à partir d'une sous-bande inférieure d'extraction 1. Ce type de laser est toutefois limité par le fait que les porteurs introduits par le dopage de la structure pour le transport électronique introduisent des pertes optiques et donc dégradent le seuil du laser. Il est donc important d'optimiser le nombre de porteurs utiles dans la structure.

Ces dispositifs sont actuellement connus en tant que laser, la présente invention propose d'utiliser de ce type de dispositifs à cascades quantiques en tant que détecteur.

C'est pourquoi la présente invention a pour objet un nouveau type de dispositif à cascades quantiques de type détecteur comportant une sous-bande supplémentaire dont la position est optimisée de manière à limiter le dopage nécessaire pour obtenir l'effet laser.

Plus précisément la présente invention a pour objet un dispositif à cascades quantiques de type détecteur comportant deux électrodes pour appliquer un champ électrique de commande, et un guide d'ondes disposé entre les deux électrodes, ledit dispositif comprenant une région de gain formée de plusieurs couches et comprenant une alternance de strates d'un premier type définissant chacune une barrière quantique et de strates d'un second type définissant chacune un puits quantique, chaque couche de la région à gain comportant une barrière d'injection présentant une sous-bande d'injection de porteurs de charge avec un niveau inférieur d'énergie dit niveau injecteur et une zone active, ladite zone active étant formée d'un ensemble de paires de strates constituées à partir de matériaux semiconducteurs de telle manière que chacun des puits présente au moins une sous-bande supérieure dite troisième sous-bande (3), une sous-bande médiane dite seconde sous-bande et une sous-bande inférieure dite première sous-bande, la différence de potentiel entre les troisième et deuxième sous-bandes étant telle que la transition d'un électron de la troisième sous-bande à la deuxième sous-bande émet une énergie correspondant à celle nécessaire pour l'émission d'un photon, **caractérisé en ce que** :
- la zone active possède en outre une quatrième sous-bande située au dessus de la troisième sous-bande ;
- ladite quatrième sous-bande étant telle qu'en l'absence de champ électrique appliqué aux électrodes, le niveau injecteur de la barrière d'injection est inférieure au niveau de ladite quatrième sous-bande et qu'en présence d'un champ appliqué aux électrodes le niveau injecteur de porteurs de charge (i) devient supérieur ou égal au niveau de la quatrième sous-bande, de manière à générer un phénomène de relaxation rapide entre le niveau injecteur et la quatrième sous-bande, la quatrième sous bande étant à une distance en énergie de la troisième sous bande permettant une relaxation par phonon optique,
et en ce qu' en l'absence de champ appliqué sur les électrodes, la troisième sous-bande est située à un niveau supérieur à celui de la sous-bande d'injection, permettant à cette sous-bande d'assurer une fonction d'extraction d'électrons sous l'action d'une absorption de photons.

Selon une variante de l'invention, la quatrième sous-bande et la troisième sous-bande présentent une différence d'énergie d'environ quelques dizaines de meV.

L'invention a ainsi pour objet un dispositif à cascades quantiques fonctionnant en tant que détecteur sans tension appliquée au niveau des électrodes, la troisième sous-bande étant située à un niveau sensiblement égal à celui de la sous-bande d'injection, permettant à cette sous-bande d'assurer une fonction d'extraction d'électrons sous l'action d'une absorption de photons.

Selon une variante de l'invention, le dispositif comprend un substrat de type InP ou GaAs ou GaSb ou InAs.

Selon une variante de l'invention, le premier matériau semiconducteur est de type AlGaAs ou AlInAs ou AlSb ou InAs ou AlGaSb...

Selon une variante de l'invention, le second matériau semiconducteur est de type InGaAs ou AlGaAs ou AlSb ou InAs ou AlGaSb.

L'invention sera mieux comprise et d'autres avantages apparaîtront à la lecture de la description qui va suivre donnée à titre non limitatif et grâce aux figures annexées parmi lesquelles :
- la figure 1 illustre un exemple de laser à cascades quantiques selon l'art connu ;
- la figure 2 illustre un exemple de dispositif à cascades quantiques selon l'invention fonctionnant en tant que détecteur sans champ électrique appliqué.

Avantageusement le dispositif de l'invention se comporte comme un dispositif détecteur en absence de champ électrique appliqué.

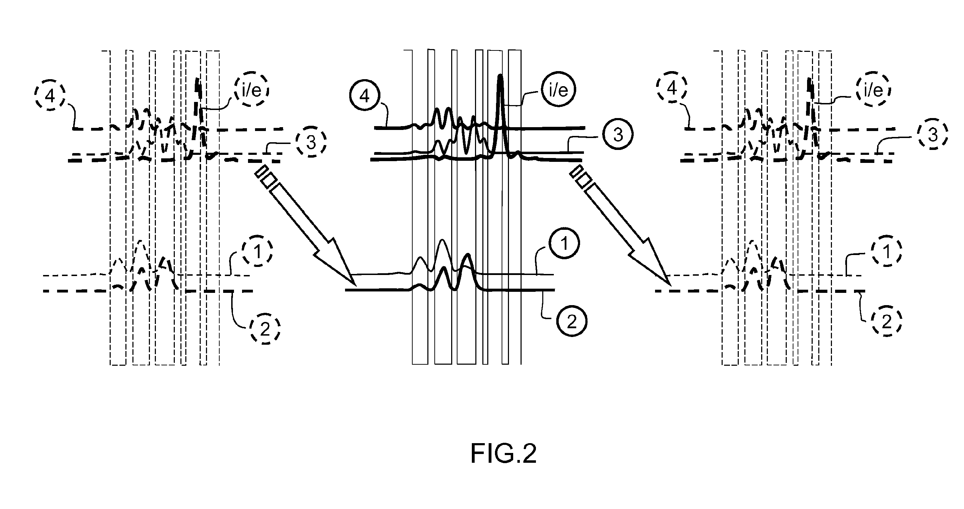

La figure 2 illustre à cet effet la position des différentes sous-bandes i, 4, 3, 2 et 1. En absence de champ appliqué, la sous-bande 2 est positionnée à un niveau inférieur à celui de la sous-bande 1.

De manière générale, lorsque des photons d'énergie E = hv sont absorbés au niveau du dispositif à cascades quantiques, des porteurs de charge sont amenés à passer de la sous-bande 2 à la sous-bande 3, la collection par un circuit électrique extérieur de ces électrons pouvant être réalisée au niveau de la troisième sous-bande sur laquelle ils ont été portés par un éclairement infrarouge et ainsi permettre la détection de cet éclairement. Selon le principe alors utilisé, les électrons situés sur une sous-bande de niveau inférieur sont portés sur une sous-bande de niveau supérieur, leur permettant d'être extraits.

Selon le dispositif de l'invention, la sous-bande correspondant au niveau injecteur i devient le niveau extracteur. En effet par absorption de photons, des électrons portés au niveau de la sous-bande 3, peuvent être extraits au niveau de la sous-bande injecteur comme mis en évidence sur la figure 3, puisque cette dernière se trouve être à un niveau énergétique plus bas que la sous-bande 3. La flèche représentée illustre la relaxation des porteurs vers le niveau 2 de la cascade suivante, conduisant au déplacement de l'électron photoexcité.

## Revendications

1. Dispositif à cascades quantiques de type détecteur comportant deux électrodes pour appliquer un champ électrique de commande, et un guide d'ondes disposé entre les deux électrodes, ledit dispositif comprenant une région de gain formée de plusieurs couches et comprenant une alternance de strates d'un premier type définissant chacune une barrière quantique et de strates d'un second type définissant chacune un puits quantique, chaque couche de la région à gain comportant une barrière d'injection présentant une sous-bande d'injection de porteurs de charge avec un niveau inférieur d'énergie dit niveau injecteur (i) et une zone active, ladite zone active étant formée d'un ensemble de paires de strates constituées à partir de matériaux semiconducteurs de telle manière que chacun des puits présente au moins une sous-bande supérieure dite troisième sous-bande (3), une sous-bande médiane dite seconde sous-bande (2) et une sous-bande inférieure dite première sous-bande (1), la différence de potentiel entre les troisième et deuxième sous-bandes étant telle que la transition d'un électron de la troisième sous-bande à la deuxième sous-bande émet une énergie correspondant à celle nécessaire pour l'émission d'un photon, **caractérisé en ce que** :
- la zone active possède en outre une quatrième sous-bande (4) située au dessus de la troisième sous-bande ;
- ladite quatrième sous-bande étant telle qu'en l'absence de champ électrique appliqué aux électrodes, le niveau injecteur de la barrière d'injection est inférieure au niveau de ladite quatrième sous-bande et qu'en présence d'un champ appliqué aux électrodes le niveau injecteur de porteurs de charge (i) devient supérieur ou égal au niveau de la quatrième sous-bande, de manière à générer un phénomène de relaxation rapide entre le niveau injecteur et la quatrième sous-bande, la quatrième sous bande étant à une distance en énergie de la troisième sous bande permettant une relaxation par phonon optique,
et **en ce qu'** en l'absence de champ appliqué sur les électrodes, la troisième sous-bande est située à un niveau supérieur à celui de la sous-bande d'injection, permettant à cette sous-bande d'assurer une fonction d'extraction d'électrons sous l'action d'une absorption de photons.

2. Dispositif à cascades quantiques selon la revendication 1, **caractérisé en ce que** la quatrième sous-bande et la troisième sous-bande présentes une différence d'énergie d'environ de quelques dizaines de meV.

3. Dispositif à cascades quantiques selon l'une des revendications 1 ou 2, **caractérisé en ce qu'**il émet une émission laser dans l'infra-rouge sous l'action d'un champ électrique appliqué sur les électrodes.

4. Dispositif à cascades quantiques selon l'une des revendications 1 à 3, **caractérisé en ce qu'**il comprend un substrat de type InP ou GaAs ou GaSb ou InAs.

5. Dispositif à cascades quantiques selon l'une des revendications 1 à 4, **caractérisé en ce que** le premier matériau semiconducteur est de type AlGaAs ou AlInAs ou AlSb ou InAs ou AlGaSb..

6. Dispositif à cascades quantiques selon l'une des revendications 1 à 5, **caractérisé en ce que** le second matériau semiconducteur est de type InGaAs ou AlGaAs ou AlSb ou InAs ou AlGaSb.
